Europäisches Patentamt

European Patent Office

Office européen des brevets

(11) Publication number: **0 439 094 A1**

# EUROPEAN PATENT APPLICATION

(21) Application number: 91100688.0

(51) Int. Cl.5: **H01L 31/0352**

(22) Date of filing: 21.01.91

(30) Priority: **22.01.90 EP 90101240**

(43) Date of publication of application:
**31.07.91 Bulletin 91/31**

(84) Designated Contracting States:
**DE FR GB IT NL**

(71) Applicant: **Max-Planck-Gesellschaft zur Förderung der Wissenschaften e.V.**
**Bunsenstrasse 10**
**W-3400 Göttingen(DE)**

(72) Inventor: **Wieck, Andreas Dirk, Dr.**
**Brandenkopfweg 32**
**W-7032 Sindelfingen(DE)**
Inventor: **Sigg, Hans, Dr.**
**University of Iceland**
**107 Reykjavik(IS)**
Inventor: **Ploog, Klaus, Dr.**
**Furtwänglerstrasse 99**
**W-7000 Stuttgart 1(DE)**

(74) Representative: **Dipl.-Phys.Dr. Manitz**
**Dipl.-Ing.Dipl.-Wirtsch.-Ing. Finsterwald**
**Dipl.-Phys. Rotermund Dipl.-Chem.Dr. Heyn**
**B.Sc.(Phys.) Morgan**
**Robert-Koch-Strasse 1**
**W-8000 München 22(DE)**

(54) **A wavelength sensitive photon detector.**

(57) We observe a photon-drag voltage along the optical path of photons propagating in the plane of an unbiased 2-Dimensional Electron Gas in GaAs quantum wells of a semiconductor device. This voltage is induced by momentum transfer from 10 $\mu$m wavelength photons to the electrons, resonantly matched in their intersubband energy to the photons by appropriate choice of the 8.2 nm well width. The voltage is reversed when the propagation direction of the photons is inversed. Moreover, the sign of the voltage also changes by sweeping the photon energy through the intersubband resonance condition in agreement with current theory. This photon-drag voltage can be readily measured and enables the semiconductor device to be operated as a wavelength sensitive photon detector of small size and high response speed.

## A WAVELENGTH SENSITIVE PHOTON DETECTOR

The present invention relates to a detector in accordance with the preamble of claim 1, i.e. to a detector comprising an undoped, semi-insulating gallium arsenide crystal of for example 300 $\mu$m thickness on which are deposited GaAs and $Al_xGa_{1-x}As$ layers of different thicknesses, e.g. by means of molecular beam epitaxy or other epitaxial techniques, with some of the AlxGa$_{1-x}$As layers being n-doped with silicon which leads to a concentration of electrons in the GaAs layers, i.e. in the material of the smaller bandgap (so-called quantum-wells QW), whereby the thickness of these GaAs layers is selected to determine the position of the energy level (subbands) of the electronic system of which only the lowest is occupied, whereby transitions can be stimulated by incident photon radiation from this basic state into higher subbands (inter-subband resonance) and whereby the photons not only transfer energy but also an impulse (momentum) to the electrons, with a part of the degree of order of the photons being transferred to the electrons, i.e. the electrons reduce their entropy which passes into the photons, with the above processes causing a voltage drop along the photon path which can be determined by contacts arranged one after the other along this path, thus converting photons whose energies lie close to the inter-subband energies into detectable electrical signals, and with the speed of the detector being determined by the elastic relaxation times of the electrons which lie around a few pico-seconds.

The object underlying the present invention is to provide an efficient detector of this kind which can be readily manufactured and which can optionally be tuned to detect photons of a specific wavelength or to detect photons with wavelengths within a predetermined range. The wavelength sensitive photon detector proposed here should not only be of fast response and simple design but also of small size. Ways of satisfying this object which can be used individually or in combination are set forth in the characterizing part of claim 1.

More specifically the detector of the present invention is characterised by any one or more of the following features either alone or in combination:

a) at least one of the input faces of the crystal is ground at the Brewster angle (for example 74$^°$ for GaAs) relative to the quantum well plane so that only the polarization of the E vector which stands perpendicular to the quantum well is refracted into the crystal, this being the only polarization which can stimulate the inter-subband transitions, with the unnecessary parallel polarization, which eventually disturbs due to a heating effect, being kept away from the system;

b) the detector is made longer than it is high so that a multiple contact is achieved between photons and electrons which leads to a multiplication of the effect;

c) the layer resistance of the QW is adapted by the doping and/or the number of the QW to the impedance of the attached high frequency line, whereby an ideal, reflection-free, electrical coupling results, in particular at high frequencies;

d) the quantum well thickness which is determined during manufacture serves for the coarse tuning of the detector, with 8.2 nm thickness thereby corresponding to a photon wavelength of approximately 10 $\mu$m, and with the fine tuning being effected by the doping, use being made of the known effect (Chen et al. Surface Science 58, 263 (1976) that the depolarization effect shifts the inter-subband resonance energy to higher resonance energies with increasing electron concentration;

e) the detector is usable without restriction from low temperatures up to room temperature, drag voltages of up to 250 mV having been measured at $T = 300$ K;

f) a magnetic field B which is applied from the outside and which is directed parallel to the quantum well increases the inter-subband resonant energy by an amount proportional to $B^2$, use being made of the "diamagnetic shift" (dissertation by A.D. Wieck 1987) and is thus exploited to tune the detector frequency-wise from the outside;

g) the detector is operated without a power supply or amplifier simply as a two-pole signal source;

h) by manufacturing quantum wells of different thickness on the same crystal a whole series of frequencies is detectable with the same detector, attention being paid to the fact that the positive signals do not compensate the negative signals to zero, i.e. the thickness difference of the quantum wells may not be too small;

i) by displacing the first stimulated subband into a continuum (i.e. above the walls of the quantum well) the scattering time $\tau_2$ can be greatly reduced, thereby leading to an amplification of the Drag effect, with this displacement being preferably attained by a reduction of the x-value of $Al_xGa_{1-x}As$, since the wall height of the quantum wells amounts to approximately 100 meV per x = 10%;

j) a "wave sump" is provided at the rear end of the crystal by roughening the output face and/or by coating the same, for example with an absorbent paint or a resistive metal such as NiCr, thereby avoiding back reflections or standing waves, so that only the forwardly propagating photons are active and the effect is ideally exploited;

k) any other III-V semiconductor system is substituted for the GaAs/AlGaAs system.

The physics underlying this invention will now be described in detail with reference to prior art papers.

The photon-drag effect (PDE is the light-induced particle drift due to the momentum transfer from photons to the particles. These particles may be atoms in a gas [1,2] or electrons in a solid. In the latter case the PDE induces a voltage drop along the way of the photons in the solid, which can be detected via electric probes at different sites along the optical path. Since the PDE-response time is correlated to the very short momentum relaxation time of the charge carriers, various scattering mechanisms can be sensed with this effect and there are potential applications as rapid photon detectors. A lot of investigations have been performed on heavily p-doped Ge, where the photons induce transitions between heavy- and light-hole states, leading to the momentum transfer from photons to holes and thus to the photon-drag voltage [3,4,5,6,7]. However, in this case only a small fraction of the carriers is in resonant interaction with photons of a given energy due to the high non-parallelism of the valence energy bands in Ge, thus reducing the efficiency of the PDE. This situation changes drastically, if the energy bands of the ground and the excited states are parallel, which occurs in Landau bands in a magnetic field (cyclotron-resonance or spin-resonance) and in the subbands of a 2-dimensional electron gas (2DEG). Whereas theory predicts PDE in all three cases, [8,9,10,11] up to now and to our knowledge, only the cyclotron-resonance PDE[12] has been observed experimentally, [13]. In a recent paper, Luryi [10] predicted the existence of the PDE in a 2DEG, which should be enhanced by the parallel subbands and different momentum relaxation times in the two lowest subbands. The aim of this present proposal is to improve the performance of the Luryi system and, as will be seen below, to give the first experimental evidence for this enhanced PDE in a 2DEG.

The invention will now be described in more detail with reference to the accompanying table and drawings which show:

Fig. 1
a) Intersubband resonances measured in transmittance of single (sample A) and 30 period (sample B) 8.2 nm thick GaAs - $Al_{0.35}Ga_{0.65}As$ quantum wells at temperatures T = 10 K and T = 300 K, respectively. The $CO_2$ laser bands used in the following figures are indicated on the wave number scale at the bottom.

b) Schematical sketch of the sample geometry with the incident light wave-vector $\bar{q}$ in the plane of the 2DEG. V denotes the electric potential measured along the optical path in y-direction, whereas V is measured perpendicularly to $\bar{q}$. Shaded areas indicate contact metallisations.

c) Non-vertical transitions of photons of wave vector $\bar{q}$ and energy $\hbar\omega$ between the lowest and the first excited parabolic subband with the $\bar{k} = 0$ ISR energy $\hbar\omega_{21}$. Note that for $\hbar\omega < \hbar\omega_{21}$, only transitions with negative $k_y$ are possible, whereas for $\hbar\omega > \hbar\omega_{21}$ only transitions with positive $k_y$ are excited. For clarity, $\bar{q}$ has been enlarged by a factor of about $10^3$ in this figure.

Fig. 2
a) $CO_2$ laser power for different lines of the 10P band, representing a quasi-frequency-sweep.

b, c and d) Room-temperature photon drag effect voltage versus frequency for $\hbar\omega < \hbar\omega_{21}$ and different experimental setups as indicated on the right hand side insets. In reversing $\bar{q}$, the drag voltage is inversed. The transverse photon-drag is about one order of magnitude smaller (d) than the longitudinal (b,c) one.

Fig.3

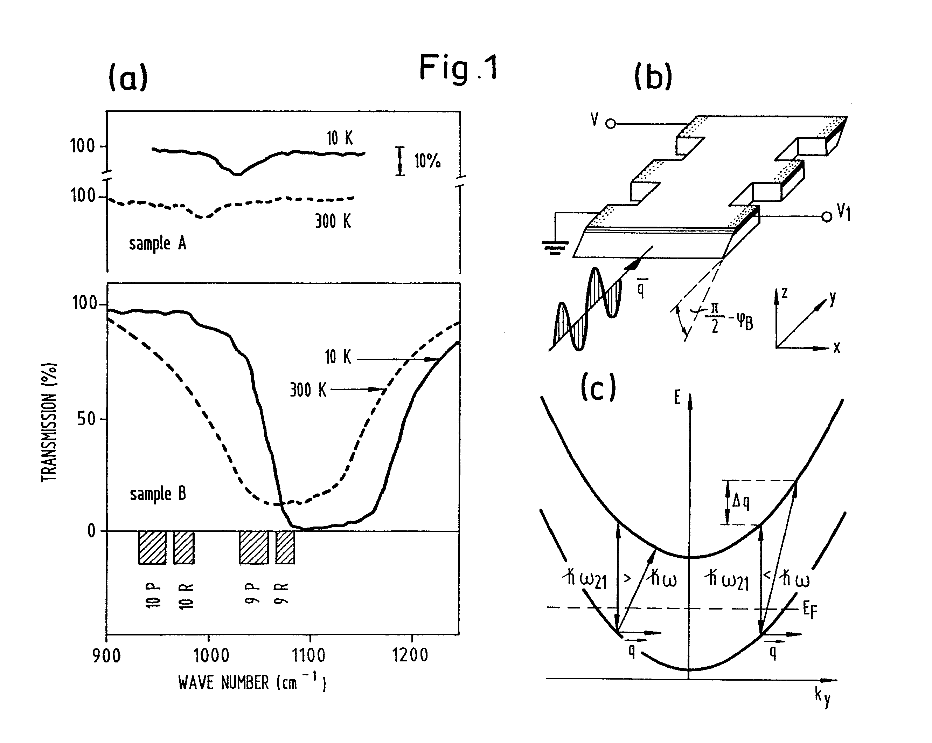

Low-temperature photon-drag voltage (upper traces) and corresponding laser power (lower traces) for a wide spectrum of $CO_2$-laser lines. Increasing the photon energy from below to above the intersubband energy of 1027cm$^{-1}$ (see Fig. 1a) changes the sign of the induced drag voltage from negative to positive.

Fig.4

Experimental intersubband resonance transmission change per transversed quantum well from Fig. 1a (o) and photon-drag short-circuit current, normalised on the laser power density and sample length (*), respectively. Lines are guides to the eye. The inset shows calculated spectra from Ref. 11, whose parameters are very close to the experimental ones as indicated in the figure. The axis scales of the inset refer to the lettering of the main figure.

Fig.5

A schematic diagram of a device in accordance with the present invention analogous to Fig. 1b and showing the connection to a coaxial cable.

Fig.6

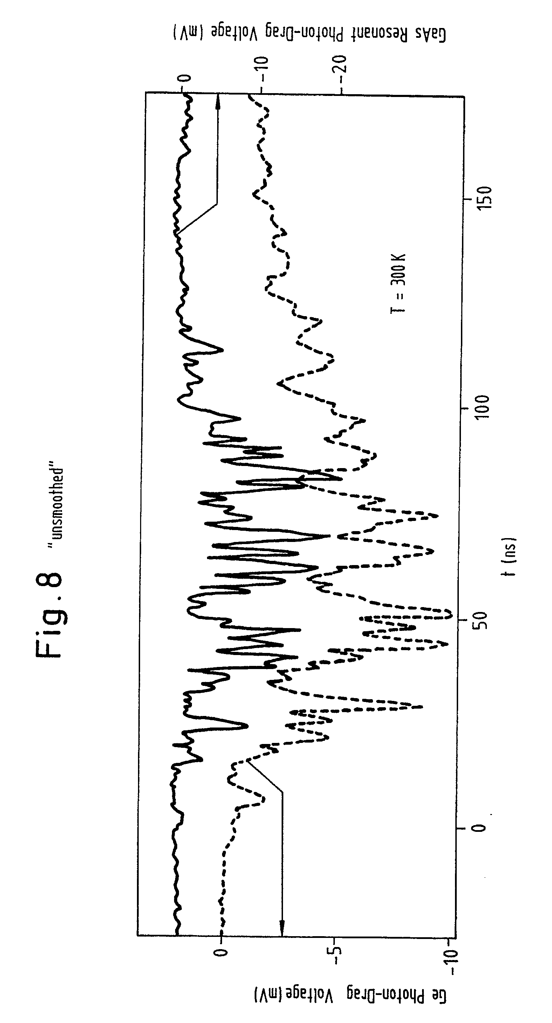

A schematic view of the experimental arrangement used to produce the curves of Figs. 7 and 8.

Fig.7

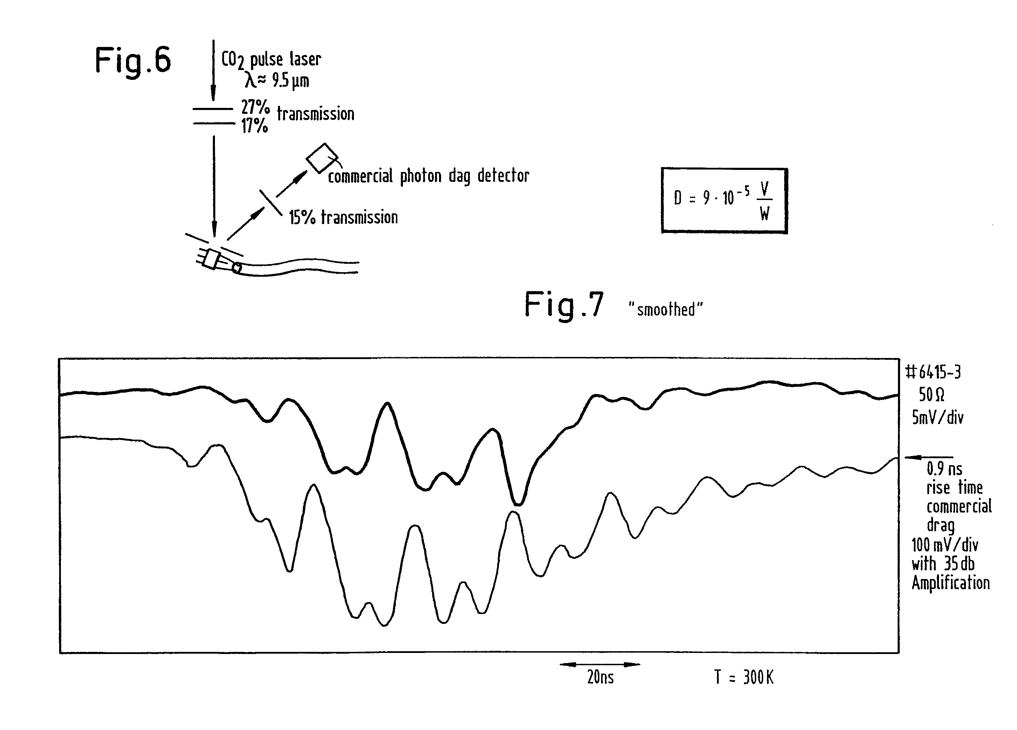

A voltage/time characteristic measured using the experimental set-up of Fig. 6. The upper solid curve applies to a two-terminal device in accordance with the present invention without applied bias, with the measurements being taken on a Hewlett Packard Digital Oscilloscope with 1 ns sampling and an input resistance of 50 ohms with a vertical sensitivity of 5 mV per division. The lower curve is a comparison curve for a conventional germanium detector which in actual fact was 1000 times larger than the detector of the invention. The output of the oscilloscope is shown here in the smoothed form.

Fig.8

The output of the oscilloscope used for the measurements of Fig. 7 in unsmoothed form. Again the upper curve applies to the device of the invention and the lower curve to the comparison device. These curves make it clear that the device of the invention has a high signal to noise ratio output.

Table 1:

Electron concentration n, mobility $\mu$, and scattering times $\tau_1$ in the lowest and $\tau_2$ in the first excited subband for sample A. While n, $\mu$, and $\tau_1$ are deduced from Hall measurements, $\tau_2$ is measured via the width of the intersubband resonance (see text). The experimental accuracy for all values is 10%.

The key point for the successful experiment is the precise sample fabrication, i.e. the intentional matching of the quantum well width (and thus the intersubband energy) with the spectral range of the photon source. In order to get easily achievable and stable infrared power densities into the sample, we choose as photon source a $CO_2$ laser. As the center wavelength of the $CO_2$ modes is 10 $\mu$m, the intersubband-resonance energy has to match the corresponding energy of 124 meV. The appropriate quantum well width evaluated by interpolation of the known intersubband-resonance energies [14,15] is 8.2 nm. This width corresponding to 29 GaAs monolayers must be attained precisely since a deviation of only one monolayer changes the intersubband energy by 4.5%[15], which is at the band limits of the $CO_2$ laser. We therefore grow the sample by Molecular Beam Epitaxy: on 300 $\mu$m thick semi-insulating GaAs, we deposit 200 nm GaAs, followed by 300 nm $Al_{0.35}Ga_{0.65}As$ and then a Si-doped ($10^{18}cm^{-3}$)5nm $Al_{0.35}Ga_{0.65}As$ layer. On this last layer we then grow a 15 nm $Al_{0.35}Ga_{0.65}As$ spacer (*) and the 8.2 nm thick GaAs quantum well (*), followed in a symmetrical manner by the 15 nm $Al_{0.35}Ga_{0.65}As$ spacer (*), the 5 nm Si-doped $Al_{0.35}Ga_{0.65}As$, 300 nm $Al_{0.35}Ga_{0.65}As$, and 5 nm GaAs. This single-quantum well is denoted sample A, whereas sample B comprises a 30-quantum well structure, in which the sequence (*) plus 10 nm Si-doped ($10^{18}cm^{-3}$)$Al_{0.35}Ga_{0.65}As$ is repeated 29 times before growing the 30th quantum well similar to the single well of sample A. Alloyed AuGe contacts to the mesa-etch defined area of 3 x 6 mm² (Fig. 1b) allow Hall measurements as well as the observation of the photon-drag voltage. Table 1 shows carrier concentration n, mobility $\mu$ and the corresponding momentum scattering time in the lowest subband $\tau_1 = m\mu/e$, where m is the effective mass of $0.07m_e$. The sample is mounted in good thermal contact to a liquid-He cooled cold finger cryostat with optical access via two windows. Similar to previous intersubband resonance (ISR) experiments on GaAs,[16] we use a quasi-stripline technique to couple the radiation into the sample: Wedging and polishing both the entrance and the exit facet for the beam at Brewster's angle $\phi_B = 74°$ with respect to the normal of the 2DEG (Fig. 1b), the radiation inside the sample is p-polarised (components of $\bar{E}$ ∣ 2DEG) which is the only mode to excite ISR. A good parallelism between the two facet planes is necessary to get the transmitted light in parallel with the direction of the incident light. The radiation passing the sample is reflected approximately 10 times at the frontside and the backside of the sample, traversing 20 times the 2DEG. Care has been taken to not illuminate the contact regions by placing an aperture of 0.3 x 3 mm in front of the sample and to focus the radiation onto the sample such that the transmission is the strongest. The transmitted intensity is detected by a liquid-$N_2$ cooled InSb detector or a piezoelectric detector, respectively.

In order to estimate the ISR-energy,[17] we first perform transmission experiements with a Fast scan Fourier Transform spectrometer. Spectra taken at room temperature and low temperature (T = 10K), normalised to the frequency response without sample, are shown in Fig. 1a. Intersubband resonances are observed for both sample A and sample B. The increase of the resonance energy with decreasing temperature is a known feature of the ISR in quantum wells but not yet well understood theoretically,[15]. In the single well (sample A) the ISR exhibits a peak height of 11% at T = 10 K. The full width at half maximum (FWHM) $2\hbar y$ is estimated to be 5.2meV, where $2\gamma = \frac{1}{\tau}_1 + \frac{1}{\tau}_2$ with the momentum scattering time $\tau_1$ in the lowest and $\tau_2$ in the first excited subband, respectively.[10,11] As the energy of the excited subband is 3.6 times higher than the optical phonon energy, $\tau_2$ is strongly limited by phonon emission and thus governs the width of the ISR. For this reason, the ISR does not become much broader in raising T to room temperature. In principle, non-parabolicity can also lead to a broadening of the ISR due to not completely parallel subbands. However, even a theoretically assumed mass diference of 10% between the two subbands only weakly broadens the ISR,[15]. The scattering times $\tau_2$ deduced from the FWHM are listed in Table 1. They are significantly shorter than the corresponding $\tau_1$ values, which is a necessary condition for the existence of the enhanced photon drag effect,[10,11].

Intersubband resonances in the multiple quantum wells of sample B are much stronger than in the single quantum well discussed before. The lineshape becomes saturated and the transmission of the sample dramatically drops to zero in a frequency band wider than $60cm^{-1}$. We concentrate in this discourse on the spectra of the single well sample, in which the total absorption is only of the order of 10% and the photon flux is thus distributed homogeneously over the whole sample length.

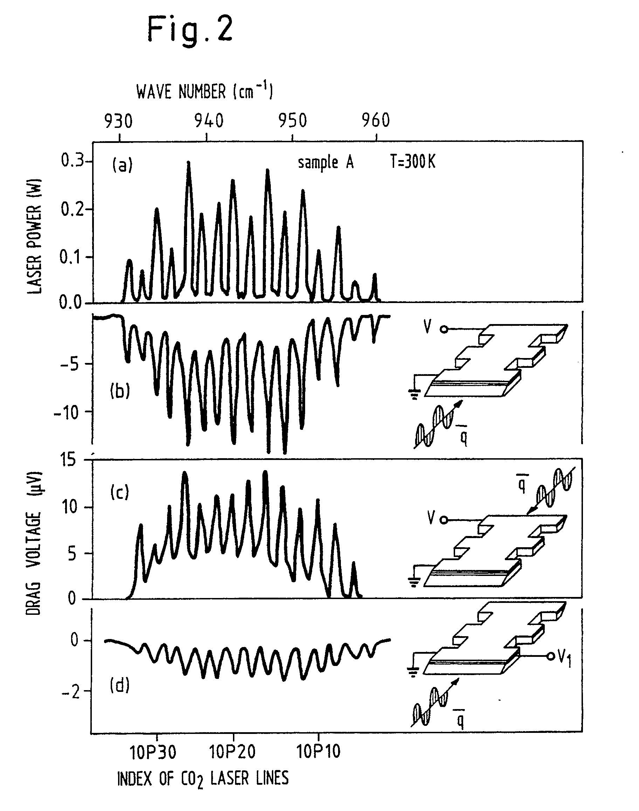

In Fig. 2 the photon-drag voltage and the corresponding laser power are shown for laser lines of the 10P band. By smoothly tilting the line-selecting grating of the laser by a motor system, we tune the laser over all possible lines, recording the intensity and drag voltage via standard lock-in techniques versus the tilt angle of the grating. Whereas the single laser lines represent distinct frequencies, the closely spaced line spectrum allows a quasi-frequency sweep.

The geometrical arrangement of the contacts and the direction of the incident light wave vector q are sketched on the right hand side of Fig. 2. In Fig. 2b the room temperature drag voltage V is plotted for the 10P band. As the photon energy $\hbar\omega$ is smaller than the ISR energy, only ISR transitions with negative $k_y$ - (i.e. electron wave vector $\vec{k}$ antiparallel to $\vec{q}$ are excited, inducing holes with negative $k_y$ in the lowest subband and electrons with a smaller negative $k_y$ in the first excited subband (see Fig. 1c). Because of $\tau_2 < \tau_1$ the excited electrons loose their direction more rapidly than the holes in the lowest subband. This leads to a net current of holes in direction of $-\vec{q}$, the enhanced PDE,[10,11]. The corresponding negative drag voltage V is exactly, what we measure in Fig. 2b. A crucial test for the nature of this observed voltage is its behavior in reversing the photon path by turning the sample. In this case, the photon-drag voltage should only change its sign. Once again this is exactly what we observe (Fig. 2c).

This longitudinal drag voltage at room temperature is as high as $14\mu V$ for a laser power of 0.3W. The transverse photon drag, measured with the potential probes located on a line perpendicular to $\vec{q}$ (Fig. 2d), is about 10 times smaller than the longitudinal one. Theoretically, the transverse photon drag should be zero for symmetry reasons. In fact, the small voltages $V_t$ recorded here vary from contact pair to contact pair even in their sign, indicating that residual transverse light modes exist in the crystal.

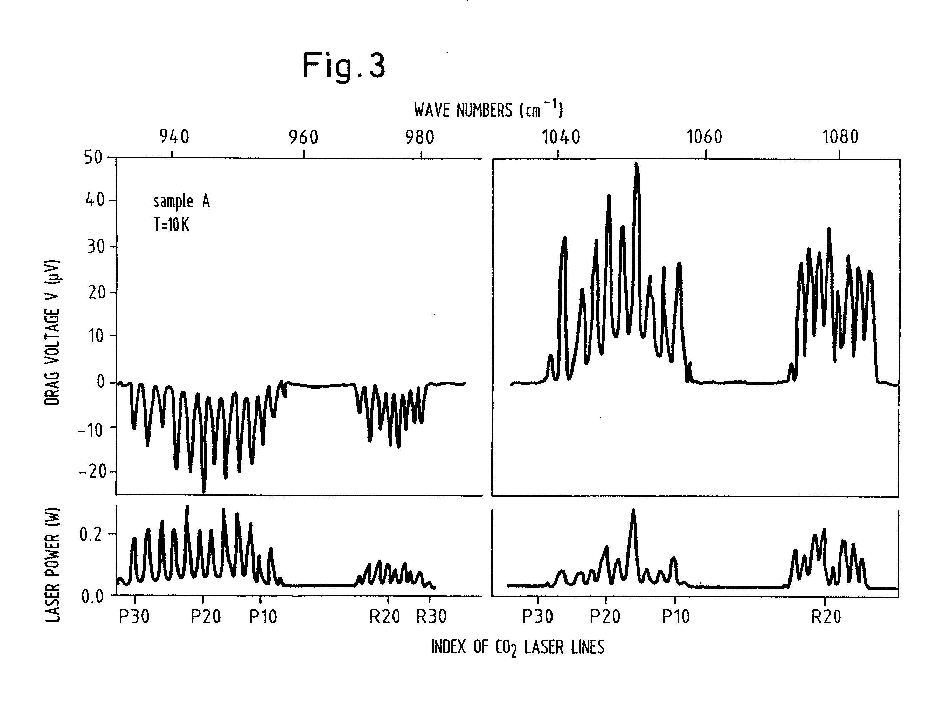

In Fig. 3, the photon-drag voltage measured at low temperatures in the configuration of Fig. 2b is plotted over the whole frequency range of the $CO_2$ laser. The striking feature of this plot is that the drag voltage changes its sign when the photon energy is raised above the ISR energy of $1027cm^{-1}$ measured in Fig. 1a. Under this condition, only transitions with positive $k_y$ are allowed (see Fig. 1c), leaving unoccupied states with $k_y > 0$ in the lowest subband. They lead to a net hole current in $k_y$ direction, and thus to a positive drag voltage. The sign change of the drag voltage in the as-observed polarity is the specific signature of the resonantly enhanced photon-drag effect in a 2DEG,[10,11].

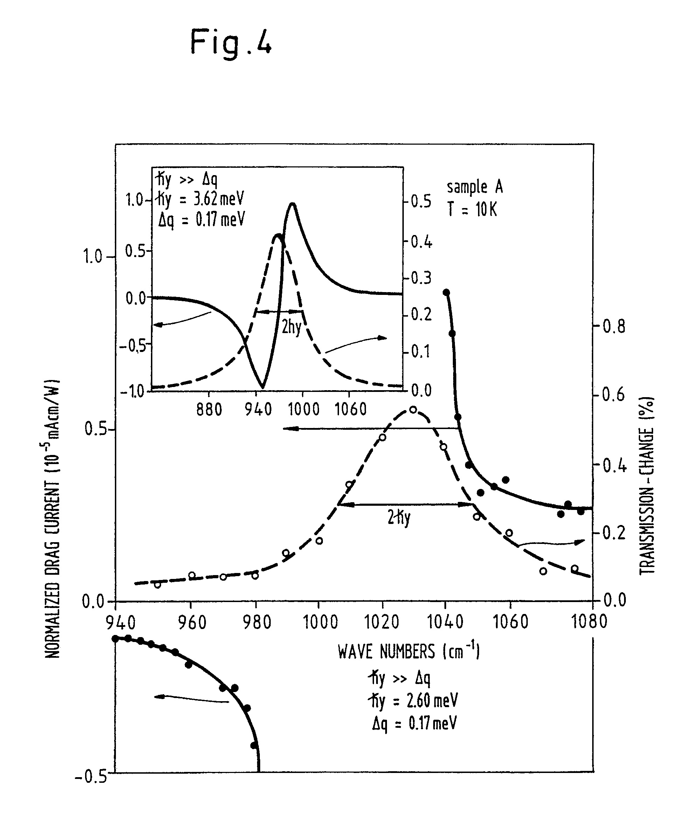

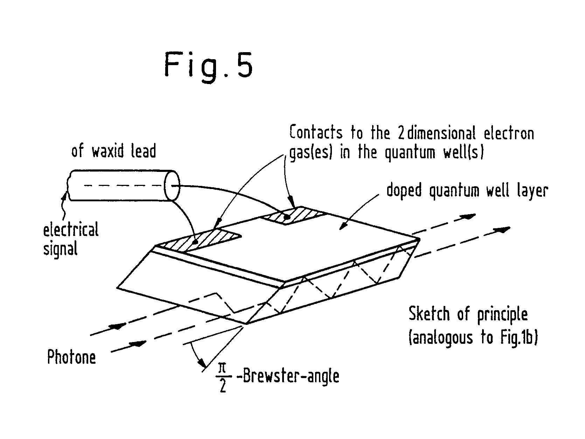

In Fig. 4, the drag current is normalised on the laser power and plotted versus frequency. We obtain this short-circuit drag current in dividing the measured open-loop drag voltage by the source impedance of the sample of about $1k\Omega$. In addition, the transmission change due to the intersubband excitation is shown on the same frequency scale. The resonant enhancement of the drag voltage in the vicinity of the ISR is evident. The slopes of the positive and negative branches suggest a singular point very close to the ISR energy, where the PDE vanishes. The inset shows the theoretical prediction of the effect, which supposes almost the same parameters of n $10^{12}cm^{-2}$ and the Doppler shift $\Delta_q = 0.17meV$,[11]. Both the ISR oscillator strength and the photon-drag current coincide within 30% with the observed values, which can be regarded as a satisfactory agreement.

On sample B, we observe only a negative drag voltage of the same height as in sample A, because the ISR lies just above the $CO_2$ laser mode range. This sample is well matched to $50\Omega$ impedances, and we can probe the speed of the PDE response via 100ns rise-time pulses of the laser. The laser intensity

evolution of the pulses is accurately reproduced in the photon-drag voltage, indicating that inherent time constants are much shorter than 10ns. This observation confirms that thermal effects at the contacts or phonon drag effects are not important in measurements presented here, because their time constants are given by the sample dimensions divided by the sound velocity, which is in the order of several μs.

In conclusion, we present first experimental proof of a resonant photon-drag effect in a 2DEG, which is due to momentum transfer between photons and electrons. It leads to a voltage drop along the optical path in the sample, which offers the feasibility of very fast and simple radiation detectors. Since the effect depends strongly on the relaxation times in different subbands, the kinetics of various scattering mechanisms can be studied. The quantitative agreement between theory and experiment is surprisingly good and offers an understanding not only of the energy but also of the momentum transfer between photons and electrons in solids.

The device of the invention has the particular advantage that no power supply is necessary to operate it.

**REFERENCES,** the content of which is incorporated herein by reference

[1] H.G.C. Werij, J.E.M. Haverkort, and J.P. Woerdman, Phys.Rev. A 33, 3270 (1986).
[2] H.G.C. Werij, J.E.M. Haverkort, P.C.M. Planken, E.R. Eliel, J.P. Woerdman, S.N. Atutov, P.L. Chapovskii, and F.Kh. Gel'mukhanov, Phys. Rev. Lett. 58, 2660 (1987).
[3] A.M. Danishevskii, A.A. Kastal'skii, S.M. Ryvkin, and I.D. Yaroshetskii, dzh. Eksp. Teor. Fiz. 58, 544 (1970) [Sov. Phys. JETP 31, 292 (1970)].
[4] A.F. Gibson, M.F. Kimmitt, and A.C. Walker, Appl. Phys. Lett. 17, 75 (1970).
[5] T. Kamibayashi, S. Yonemochi, and T. Miyakawa, Appl. Phys. Lett. 22, 119 (1973).
[6] P.J. Bishop, A.F. Gibson, and M.F. Kimmitt, IEEE J. Quantum Electron, QE-9, 1007 (1973).
[7] G.A.F. Ali, S. Montasser, L. Zaki, S.M. Refaei, and L.El-Nadi, Appl. Phys. A 39, 291 (1986).
[8] E.M. Skok and A.M. Shalagin, Pis'ma Zh. Eksp. Teor. Fiz. 32, 201 (1980) [JETP Lett. 32, 184 (1980)].
[9] A.M. Dykhne, V.A. Roslyakov, and A.N. Starostin, Dokl. Akad. Nauk SSSR 254, 599 (1980) [Sov. Phys. Dokl. 25, 741 (1980)].
[10] S. Luryi, Phys. Rev. Lett. 48, 2263 (1987).
[11] A.A. Grinberg and S. Luryi, Phys. Rev. B 38, 87 (1988).
[12] A.F. Kravchenko, A.M. Palkin, V.N. Sozinov, and O.A. Shegai, Pis'ma Zh. Eksp. Teor. Fiz. 38, 328 (1983) [JETP Lett. 38, 393 (1963)].
[13] J.P. Woerdman, Phys. Rev. Lett. 59, 1624 (1987).
[14] L.C. West and S.J. Eglash, Appl. Phys. Lett. 46, 1156 (1985).
[15] P. von Allmen, M. Berz, G. Petrocelli, F.K. Reinhart, and G. Harbeke, Semicond. Sci. Techn. 3, 1211 (1988).
[16] A.D. Wieck. K. Bollweg, U. Merkt, G. Weimann, and W.Schlapp, Phys. Rev. B 38, 10158 (1988).
[17] In this paper, we discuss the depolarisation-shifted ISR energy (Ref.16), neglecting in a good approximation the $\bar{k}$-dependence of the depolarisation shift.

# Table 1

| T (K) | n ($10^{12}$ $cm^{-2}$) | μ ($m^2$/Vs) | $\tau_1$ (ps) | $\tau_2$ (ps) |
|---|---|---|---|---|
| 300 | 0.59 | 0.46 | 0.18 | 0.13 |
| 10 | 0.99 | 1.98 | 0.79 | 0.15 |

## Claims

1. A detector comprising an undoped, semi-insulating gallium arsenide crystal of for example 300 μm thickness on which are deposited GaAs and $Al_xGa_{1-x}As$ layers of different thicknesses, e.g. by means of molecular beam epitaxy or other epitaxial techniques, with some of the $Al_xGa_{1-x}As$ layers being n-doped with silicon which leads to a concentration of electrons in the GaAs layers, i.e. in the material of the

smaller bandgap (so-called quantum-wells QW), whereby the thickness of these GaAs layers is selected to determine the position of the energy level (subbands) of the electronic system of which only the lowest is occupied, whereby transitions can be stimulated by incident photon radiation from this basic state into higher subbands (inter-subband resonance) and whereby the photons not only transfer energy but also an impulse (momentum) to the electrons, with a part of the degree of order of the photons being transferred to the electrons, i.e. the electrons reduce their entropy which passes into the photons, with the above processes causing a voltage drop along the photon path which can be determined by contacts arranged one after the other along this path, thus converting photons whose energies lie close to the inter-subband energies into detectable electrical signals, and with the speed of the detector being determined by the elastic relaxation times of the electrons which lie around a few pico-seconds, characterized by one or more of the following features, either alone or in combination:

a) at least one of the input faces of the crystal is ground at the Brewster angle (for example 74° for GaAs) relative to the quantum well plane so that only the polarization of the E vector which stands perpendicular to the quantum well is refracted into the crystal, this being the only polarization which can stimulate the inter-subband transitions, with the unnecessary parallel polarization, which eventually disturbs due to a heating effect, being kept away from the system;

b) the detector is made longer than it is high so that a multiple contact is achieved between photons and electrons which leads to a multiplication of the effect;

c) the layer resistance of the QW is adapted by the doping and/or the number of the QW to the impedance of the attached high frequency line, whereby an ideal, reflection-free, electrical coupling results, in particular at high frequencies;

d) the quantum well thickness which is determined during manufacture serves for the coarse tuning of the detector, with 8.2 nm thickness thereby corresponding to a photon wavelength of approximately 10 $\mu$m, and with the fine tuning being effected by the doping, use being made of the known effect (Chen et al. Surface Science 58, 263 (1976) that the depolarization effect shifts the inter-subband resonance energy to higher resonance energies with increasing electron concentration;

e) the detector is usable without restriction from low temperatures up to room temperature, drag voltages of up to 250 mV having been measured at T = 300 K;

f) a magnetic field B which is applied from the outside and which is directed parallel to the quantum well increases the inter-subband resonant energy by an amount proportional to $B^2$, use being made of the "diamagnetic shift" (dissertation by A.D. Wieck 1987) and is thus exploited to tune the detector frequency-wise from the outside;

g) the detector is operated without a power supply or amplifier simply as a two-pole signal source;

h) by manufacturing quantum wells of different thickness on the same crystal a whole series of frequencies is detectable with the same detector, attention being paid to the fact that the positive signals do not compensate the negative signals to zero, i.e. the thickness difference of the quantum wells may not be too small;

i) by displacing the first stimulated subband into a continuum (i.e. above the walls of the quantum well) the scattering time $\tau_2$ can be greatly reduced, thereby leading to an amplification of the Drag effect, with this displacement being preferably attained by a reduction of the x-value of $Al_xGa_{1-x}As$, since the wall height of the quantum wells amounts to approximately 100 meV per x = 10%;

j) a "wave sump" is provided at the rear end of the crystal by roughening the output face and/or by coating the same, for example with an absorbent paint or a resistive metal such as NiCr, thereby avoiding back reflections or standing waves, so that only the forwardly propagating photons are active and the effect is ideally exploited;

k) any other III-V semiconductor system is substituted for the GaAs/AlGaAs system.

2. A detector comprising an undoped, semi-insulating gallium arsenide crystal of for example 300 $\mu$m thickness on which are deposited GaAs and $Al_xGa_{1-x}As$ layers of different thicknesses, e.g. by means of molecular beam epitaxy or other epitaxial techniques, with some of the $Al_xGa_{1-x}As$ layers being n-doped with silicon which leads to a concentration of electrons in the GaAs layers, i.e. in the material of the smaller bandgap (so-called quantum-wells QW), whereby the thickness of these GaAs layers is selected to determine the position of the energy level (subbands) of the electronic system of which only the lowest is occupied, whereby transitions can be stimulated by incident photon radiation from this basic state into higher subbands (inter-subband resonance) and whereby the photons not only transfer energy but also an impulse (momentum) to the electrons, with a part of the degree of order of the photons being transferred to the electrons, i.e. the electrons reduce their entropy which passes into the photons, with the above processes causing a voltage drop along the photon path which can be determined by contacts arranged one after the other along this path, thus converting photons whose energies lie close to the inter-subband energies into detectable electrical signals, and with the speed of the detector being determined by the elastic relaxation times of the electrons which lie around a few pico-seconds, characterized in that

a) at least one of the input faces of the crystal is ground at the Brewster angle (for example 74° for GaAs) relative to the quantum well plane so that only the polarization of the E vector which stands perpendicular to the quantum well is refracted into the crystal, this being the only polarization which can stimulate the inter-subband transitions, with the unnecessary parallel polarization, which eventually disturbs due to a heating effect, being kept away from the system;

3. A detector in accordance with claim 2 and characterised in that
b) the detector is made longer than it is high so that a multiple contact is achieved between photons and electrons which leads to a multiplication of the effect;

4. A detector in accordance with either of claims 2 or 3 and characterised in that
c) the layer resistance of the QW is adapted by the doping and/or the number of the QW to the impedance of the attached high frequency line, e.g. by direct resistance matching, whereby an ideal, reflection-free, electrical coupling results, in particular at high frequencies;

5. A detector in accordance with any one of the preceding claims 2, 3 or 4 and characterised in that
d) the quantum well thickness which is determined during manufacture serves for the coarse tuning of the detector, with 8.2 nm thickness thereby corresponding to a photon wavelength of approximately 10 $\mu$m, and with the fine tuning being effected by the doping, use being made of the known effect (Chen et al. Surface Science 58, 263 (1976) incorporated herein by reference) that the depolarization effect shifts the inter-subband resonance energy to higher resonance energies with increasing electron concentration;

6. A detector in accordance with any one of the preceding claims 2 to 5 and characterised in that
e) the detector is usable without restriction from low temperatures up to room temperature, drag voltages of up to 250 mV having been measured at T = 300 K;

7. A detector in accordance with any one of the preceding claims 2 to 6 and characterised in that
f) a magnetic field B which is applied from the outside and which is directed parallel to the quantum well increases the inter-subband resonant energy by an amount proportional to $B^2$, use being made of the "diamagnetic shift" (dissertation by A.D. Wieck 1987, incorporated herein by reference) and is thus exploited to tune the detector frequency-wise from the outside;

8. A detector in accordance with any one of the preceding claims 2 to 7 and characterised in that
g) the detector is operated without a power supply or amplifier simply as a two-pole signal source;

9. A detector in accordance with any one of the preceding claims 2 to 8 and characterised in that
h) by manufacturing quantum wells of different thickness on the same crystal a whole series of frequencies is detectable with the same detector, attention being paid to the fact that the positive signals do not compensate the negative signals to zero, i.e. the thickness difference of the quantum wells may not be too small;

10. A detector in accordance with any one of the preceding claims 2 to 9 and characterised in that
i) by displacing the first stimulated subband into a continuum (i.e. above the walls of the quantum well) the scattering time $\tau_2$ can be greatly reduced, thereby leading to an amplification of the Drag effect, with this displacement being preferably attained by a reduction of the x-value of $Al_xGa_{1-x}As$, since the wall height of the quantum wells amounts to approximately 100 meV per x = 10%;

11. A detector in accordance with any one of the preceding claims 2 to 10 and characterised in that
j) a "wave sump" is provided at the rear end of the crystal by roughening the output face and/or by coating the same, for example with an absorbent paint or a resistive metal such as NiCr, thereby avoiding back reflections or standing waves, so that only the forwardly propagating photons are active and the effect is ideally exploited;

12. A detector in accordance with any one of the preceding claims 2 to 11 and characterised in that
   k) any other III-V semiconductor system is substituted for the GaAs/AlGaAs system.

Fig.1

# Fig.2

# Fig.3

WAVE NUMBERS $(cm^{-1})$

sample A
T=10K

DRAG VOLTAGE V $(\mu V)$

LASER POWER (W)

INDEX OF $CO_2$ LASER LINES

EP 0 439 094 A1

# Fig.4

# Fig.5

of waxid lead

Contacts to the 2 dimensional electron
gas(es) in the quantum well(s)

doped quantum well layer

electrical
signal

Sketch of principle
(analogous to Fig.1b)

Photone

$\frac{\pi}{2}$ -Brewster-angle

## Fig.6

CO$_2$ pulse laser
$\lambda \approx 9.5\,\mu m$

27% transmission
17%

commercial photon dag detector

15% transmission

$$D = 9 \cdot 10^{-5} \frac{V}{W}$$

## Fig.7   "smoothed"

#6415-3
50 Ω
5mV/div

0.9 ns
rise time
commercial
drag
100 mV/div
with 35 db
Amplification

20ns          T = 300 K

Fig.8  "unsmoothed"

T = 300 K

Ge Photon-Drag Voltage (mV)

GaAs Resonant Photon-Drag Voltage (mV)

t (ns)

EP 0 439 094 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | PHYSICAL REVIEW B, vol. 38, no. 1, 1st July 1988, pages 87-96, NY, US; A.A. GRINBERG et al.: "Theory of the photon-drag effect in a two-dimensional electron gas" * Whole document * | 1,2,5,8,9 | H 01 L 31/0352 |
| A | APPLIED PHYSICS LETTERS, vol. 53, no. 4, 25th July 1988, pages 296-298, NY, US; B.F. LEVINE et al.: "High-detectivity D*=1.0X1010 cm Hz/W GaAs/AlGaAs multiquantum well lambda=8.3 mum infrared detector" * Whole document * | 1,2,5, 8-10 | |
| A | SEMICONDUCTOR SCIENCE AND TECHNOLOGY, vol. 3, no. 7, July 1988, pages 722-725, Bristol, GB; M.J. KANE et al.: "Inter-sub-band absorption in GaAs/AlGaAs single quantum wells" * Whole document * | 1-3,5,8 | |
| D,A | PHYSICAL REVIEW LETTERS, vol. 58, no. 21, 25th May 1987, pages 2263-2266, NY, US; S. LURYI: "Photon-drag effect in intersubband absorption by a two-dimensional electron gas" * Whole document * | 1,2,8 | |
| A | APPLIED PHYSICS LETTERS, vol. 54, no. 6, 26th June 1989, pages 2704-2706, NY, US; B.F. LEVINE et al.: "Broadband 8-12 mum high-sensitivity GaAs quantum well infrared photodetector" * Whole document * | 1,2,8,10 | |
| D,A | PHYSICAL REVIEW B, vol. 38, no. 14, 15th November 1988, pages 10158-10161, NY, US; A.D. WIECK et al.: "Combined intersubband-cyclotron resonances in a GaAs-Ga1-xAlxAs heterojunction" * Whole document * | 1,2,7,8 | |

TECHNICAL FIELDS SEARCHED (Int. Cl.5)

H 01 L

−/−

The present search report has been drawn up for all claims

| Place of search | Date of completion of search | Examiner |
|---|---|---|
| The Hague | 06 May 91 | DE LAERE A.L.C. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

             

& : member of the same patent family, corresponding document

**European Patent Office**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | SEMICONDUCTOR SCIENCE AND TECHNOLOGY, vol. 3, no. 8, August 1988, pages 797-801, Bristol, GB; F. MÜLLER et al.: "Resonance spectroscopy of InGaAs/InP quantum well sub-bands" <br> * Whole document * <br> _ _ _ _ _ | 1,2,5,8,12 | |
| | | | TECHNICAL FIELDS SEARCHED (Int. Cl.5) |

The present search report has been drawn up for all claims

| Place of search | Date of completion of search | Examiner |
|---|---|---|
| The Hague | 06 May 91 | DE LAERE A.L.C. |

CATEGORY OF CITED DOCUMENTS

X : particularly relevant if taken alone
Y : particularly relevant if combined with another document of the same catagory
A : technological background
O : non-written disclosure
P : intermediate document
T : theory or principle underlying the invention

E : earlier patent document, but published on, or after the filing date
D : document cited in the application
L : document cited for other reasons

&: member of the same patent family, corresponding document